# EUROPÄISCHE PATENTANMELDUNG

(11) **EP 3 023 801 A1**
(43) Veröffentlichungstag der Anmeldung: **25.05.2016**
(21) Anmeldenummer: 15003259.7
(22) Anmeldetag: 16.11.2015
(51) Int. Cl.: G01R 31/28, G01R 1/04

(54) **TESTKONTAKTOR ZUM KONTAKTIEREN VON HALBLEITERELEMENTEN, VERFAHREN ZUM KONTAKTIEREN VON HALBLEITERELEMENTEN UND VERWENDUNG EINES TESTKONTAKTORS**

(30) Priorität: 18.11.2014 DE 102014016995
(71) Anmelder: Yamaichi Electronics Deutschland GmbH, 85609 Aschheim-Dornach (DE)
(72) Erfinder: Quiter, Michael, 57482 Wenden (DE); Btahri, Jemei, 85609 Aschheim-Dornach (DE)
(74) Vertreter: Müller-Boré & Partner Patentanwälte PartG mbB

(57) **Zusammenfassung**

Die vorliegende Anmeldung betrifft einen Testkontaktor (10) zum Kontaktieren von Halbleiterelementen, umfassend: ein Gehäuse (14) mit einem Gehäuse-Deckel (78) zum Öffnen des Gehäuses, wobei in einem Innenraum des Gehäuses Halbleiterelemente anordenbar sind; wobei der Gehäuse-Deckel umfasst: eine erste Seitenwand (90) und eine zweite Seitenwand (90), die sich gegenüber liegen; ein Deckelelement, das die erste Seitenwand und die zweite Seitenwand verbindet und im geschlossenen Zustand des Gehäuses im Wesentlichen parallel zu den Halbleiterelementen anordenbar ist; und eine Hebelvorrichtung, welche an einer der Seitenwände angeordnet ist; wobei die Hebelvorrichtung umfasst: ein erstes Rotationsmittel (112), welches an einer Außenseite der ersten Seitenwand rotierbar angeordnet ist; zwei erste Rotations-Übertragungsmittel, welche mit dem ersten Rotationsmittel rotierbar verbunden sind, und wobei jedes der ersten Rotations-Übertragungsmittel ein erstes Eingriffsmittel aufweist; zwei erste Kraftführungsmittel (134), welche gegenüberliegend zu einer Innenseite der ersten Seitenwand angeordnet sind, wobei jedes der ersten Eingriffsmittel dazu ausgelegt ist, in ein entsprechend zugeordnetes erstes Kraftführungsmittel einzugreifen, wenn das Gehäuse geschlossen wird; ein Hebel (150), welcher mit dem ersten Rotationsmittel verbunden ist und der dazu ausgelegt ist, das erste Rotationsmittel durch ein Verschwenken des Hebels zu rotieren; wobei die ersten Eingriffsmittel durch eine Rotationsbewegung des ersten Rotationsmittels in den ersten Kraftführungsmitteln in Längsrichtung zwischen einer ersten Position und einer zweiten Position verschiebbar sind; und wobei die ersten Eingriffsmittel in der zweiten Position selbstgehemmt sind, so dass ein selbstständiges Öffnen des Gehäuse-Deckels verhindert wird.

## Beschreibung

Die vorliegende Erfindung betrifft einen Testkontaktor zum Kontaktieren von Halbleiterelementen, ein Verfahren zum Kontaktieren von Halbleiterelementen und eine Verwendung eines Testkontaktors.

Testkontaktoren bieten die Möglichkeit, eine Vielzahl von Halbleiterelementen, die auf einer Leiterplatte angeordnet sind, auf ihre Funktionsfähigkeit zu überprüfen. Hierzu wird die Leiterplatte mit den Halbleiterelementen in einen Testkontaktor eingesetzt und anschließend in einem Ofen über eine vordefinierte Zeit und bei einer vordefinierten Temperatur erhitzt. Mittels der Erhitzung soll eine künstliche bzw. beschleunigte Alterung der Halbleiterelemente erzeugt werden, um altersbedingte Defekte der Halbleiterelemente untersuchen zu können. In den Testkontaktoren sind Kontaktierungspins angeordnet, die die Halbleiterelemente kontaktieren. Nach Abschluss der Erhitzungsphase werden die Kontaktierungspins mittels eines externen Auslesegeräts kontaktiert, um die Halbleiterelemente auf ihre Funktionsfähigkeit zu überprüfen.

Um eine hohe Qualität der ausgelesenen Daten zu gewährleisten, ist es notwendig, dass die Kontaktierungspins zuverlässig kontaktiert werden und während des gesamten Testverfahrens bleiben.

Diese Aufgabe wird gemäß einem ersten Aspekt durch einen Testkontaktor zum Kontaktieren von Halbleiterelementen gelöst, welcher umfasst:
ein Gehäuse mit einem Gehäuse-Deckel zum Öffnen des Gehäuses, wobei in einem Innenraum des Gehäuses Halbleiterelemente anordenbar sind;
wobei der Gehäuse-Deckel umfasst:
   - eine erste Seitenwand und eine zweite Seitenwand, die sich gegenüberliegen;
   - ein Deckelelement, das die erste Seitenwand und die zweite Seitenwand verbindet und im geschlossenen Zustand des Gehäuses im Wesentlichen parallel zu den Halbleiterelementen anordenbar ist; und
   - eine Hebelvorrichtung, welche an einer der Seitenwände angeordnet ist; wobei die Hebelvorrichtung umfasst:
      - ein erstes Rotationsmittel, welches an einer Außenseite der ersten Seitenwand rotierbar angeordnet ist;
      - zwei erste Rotations-Übertragungsmittel, welche mit dem ersten Rotationsmittel rotierbar verbunden sind, und wobei jedes der ersten Rotations-Übertragungsmittel ein erstes Eingriffsmittel aufweist;
      - zwei erste Kraftführungsmittel, welche gegenüberliegend zu einer Innenseite der ersten Seitenwand angeordnet sind, wobei jedes der ersten Eingriffsmittel dazu ausgelegt ist, in ein entsprechend zugeordnetes erstes Kraftführungsmittel einzugreifen, wenn das Gehäuse geschlossen wird;
      - ein Hebel, welcher mit dem ersten Rotationsmittel verbunden ist und der dazu ausgelegt ist, das erste Rotationsmittel durch ein Verschwenken des Hebels zu rotieren;
wobei die ersten Eingriffsmittel durch eine Rotationsbewegung des ersten Rotationsmittels in den ersten Kraftführungsmitteln in Längsrichtung zwischen einer ersten Position und einer zweiten Position verschiebbar sind; und
wobei die ersten Eingriffsmittel in der zweiten Position selbstgehemmt sind, so dass ein selbstständiges Öffnen des Gehäuse-Deckels verhindert wird.

Als "Innenraum" des Gehäuses, in dem die Halbleiterelemente anordenbar sind, wird der Raum angesehen, der sich zwischen den Seitenwänden und dem Deckelelement erstreckt. Der Innenraum ist vorzugsweise an einer Unterseite durch ein Bodenelement begrenzt. Dieses Bodenelement kann beispielsweise durch eine Platte gebildet sein, auf oder an der eine oder mehrere Leiterplatte(n) jeweils bestückt mit einer Vielzahl von zu testenden Halbleiterelementen angeordnet werden kann.

Das Deckelelement verbindet die erste und zweite Seitenwand, so dass das Deckelelement in einem geschlossenen Zustand des Gehäuses im Wesentlichen parallel zu den einzusetzenden Halbleiterelementen angeordnet ist. Mit anderen Worten befindet sich das Deckelelement im geschlossenen Zustand des Gehäuses an einer Oberseite des Gehäuses bzw. bildet die Oberseite des Gehäuses.

Als "Außenseite" der ersten Seitenwand wird die Seite der ersten Seitenwand angesehen, die der zweiten Seitenwand abgewandt ist.

Als "Innenseite" der ersten Seitenwand wird entsprechend die Seite der ersten Seitenwand angesehen, die der zweiten Seitenwand gegenüberliegt.

Die "Längsrichtung", in der die Eingriffsmittel in den ersten Kraftführungsmitteln verschiebbar sind, erstreckt sich parallel zu dem Deckelelement und Innenflächen der Seitenwände. Innenflächen der Seitenwände werden durch Flächen der Seitenwände gebildet, die sich gegenüberliegen.

Im geschlossenen Zustand des Gehäuse-Deckels ist das Deckelelement derart angeordnet, dass dieses im Wesentlichen parallel zu den einzusetzenden Halbleiterelementen und/oder dem Bodenelement angeordnet ist und die Halbleiterelemente vorzugsweise in eine Richtung senkrecht zur Längsrichtung presst. Durch eine Verschiebung der Halbleiterelemente in eine Richtung senkrecht zur Längsrichtung sind die Halbleiterelemente zu später näher beschriebenen Kontaktierungspins gedrückt und somit durch diese kontaktiert. Die Kontaktierungspins können nach der Erhitzungsphase dazu verwendet werden, die Halbleiterelemente auszulesen.

Mit anderen Worten ist das Deckelelement entscheidend dafür, dass die einzusetzenden Halbleiterelemente kontaktierbar sind. Nur durch einen vollständig geschlossenen Gehäuse-Deckel kann dieser kontaktierte Zustand sichergestellt werden. Durch die Selbsthemmung der ersten Eingriffsmittel an der zweiten Position in den ersten Kraftführungsmitteln kann verhindert werden, dass sich der Gehäuse-Deckel selbstständig wieder öffnet. Ein ungewolltes Verlassen des kontaktierten Zustands der Halbleiterelemente kann somit zuverlässig verhindert werden.

Vorzugsweise ist die Hebelvorrichtung an der ersten und der zweiten Seitenwand angeordnet;
wobei die Hebelvorrichtung zusätzlich umfasst:
- ein zweites Rotationsmittel, welches an einer Außenseite der zweiten Seitenwand rotierbar angeordnet ist;
- zwei zweite Rotations-Übertragungsmittel, welche mit dem zweiten Rotationsmittel rotierbar verbunden sind, und wobei jedes der zweiten Rotations-Übertragungsmittel ein zweites Eingriffsmittel aufweist;
- zwei zweite Kraftführungsmittel, welche gegenüberliegend zu einer Innenseite der zweiten Seitenwand angeordnet sind, wobei jedes der zweiten Eingriffsmittel dazu ausgelegt ist, in ein entsprechend zugeordnetes zweites Kraftführungsmittel einzugreifen, wenn das Gehäuse geschlossen wird;
wobei der Hebel mit dem ersten und zweiten Rotationsmittel verbunden ist und der dazu ausgelegt ist, das erste und zweite Rotationsmittel durch ein Verschwenken des Hebels zu rotieren;
wobei die zweiten Eingriffsmittel durch eine Rotationsbewegung des zweiten Rotationsmittels in den zweiten Kraftführungsmitteln in Längsrichtung zwischen einer ersten Position und einer zweiten Position verschiebbar sind; und
wobei die zweiten Eingriffsmittel in der zweiten Position selbstgehemmt sind, so dass ein selbstständiges Öffnen des Gehäuse-Deckels verhindert wird.

Die Definitionen der "Innenseite" und "Außenseite" bezüglich der ersten Seitenwand gelten entsprechend auch für die "Innenseite" und "Außenseite" der zweiten Seitenwand.

Die Definition "Längsrichtung" bezüglich der Verschieberichtung der ersten Eingriffsmittel gilt entsprechend für die Verschieberichtung der zweiten Eingriffsmittel. Durch eine zusätzliche Selbsthemmung der zweiten Eingriffsmittel in der zweiten Position in den zweiten Kraftführungsmitteln kann ein selbstständiges Öffnen des Gehäuse-Deckels weiter verbessert werden.

In einer bevorzugten Ausführungsform, sind die Rotations-Übertragungsmittel, die mit demselben Rotationsmittel verbunden sind, durch eine Verschwenkbewegung des Hebels in Längsrichtung zueinander verschiebbar.

Die "Längsrichtung" entspricht hierbei der Längsrichtung, in die die Eingriffsmittel verschiebbar sind.

Durch eine Verschwenkbewegung des Hebels von einer ersten Position zu einer zweiten Position ist das Rotationsmittel um einen bestimmten Winkel verdreht. Durch diese Rotationsbewegung des Rotationsmittels sind die Rotations-Übertragungsmittel, die mit dem Rotationsmittel rotierbar verbunden sind, von einer ersten Position zu einer zweiten Position verschoben. Im Gegensatz zu dem Rotationsmittel, das ausgelegt ist, eine Rotationsbewegung auszuführen, sind die Rotations-Übertragungsmittel jedoch derart ausgelegt, eine Bewegung in Längsrichtung auszuführen. Vorzugsweise sind die Rotations-Übertragungsmittel so ausgelegt, dass sich die Rotations-Übertragungsmittel durch eine Verschwenkbewegung des Hebels in Längsrichtung auseinander bewegen bzw. sich voneinander beabstanden.

Dies gilt entsprechend für die ersten und zweiten Rotationsmittel und die ersten und zweiten Rotations-Übertragungsmittel.

Vorzugsweise sind die Kraftführungsmittel ausgebildet, die einzusetzenden Halbleiterelemente während des Schließvorgangs des Gehäuses durch das Deckelelement mit einem vordefinierten Kraftverlauf in eine Richtung senkrecht zur Längsrichtung zu drücken.

Hierdurch wird erzielt, dass zum einen die Halbleiterelemente mit einer ausreichenden Kraft zu den Kontaktierungspins verschoben.werden, so dass eine zuverlässige Kontaktierung gewährleistet werden kann. Zum anderen kann über den vordefinierten Kraftverlauf festgelegt werden, wann während des Schließvorgangs des Gehäuses wieviel Kraft aufgebracht werden soll, um die Halbleiterelemente zu verschieben. Mit einem vordefinierten Kraftverlauf kann beispielsweise ein gleichmäßiges Verschieben aller Halbleiterelemente erzielt werden, wodurch eine zuverlässige Kontaktierung aller Halbleiterelemente gewährleistet werden kann. Darüber hinaus kann mittels des Gehäusedeckels bzw. mittels des Hebelmechanismuses eine große Kraft aufgebracht werden. Insbesondere ist es bevorzugt, dass die Kraft während des Schließvorgangs linear ansteigt.

In einer bevorzugten Ausführungsform sind die Kraftführungsmittel, die derselben Innenseite einer Seitenwand gegenüberliegen, in Längsrichtung zueinander versetzt.

Mit anderen Worten sind die ersten Kraftführungsmittel, die der ersten Seitenwand gegenüberliegen in Längsrichtung zueinander versetzt. Gleiches gilt für die zweiten Kraftführungsmittel, die der zweiten Seitenwand gegenüberliegen, entsprechend.

Die Definition "Längsrichtung" bezüglich der Verschieberichtung der Eingriffsmittel gilt entsprechend auch für die Versatzrichtung der Kraftführungsmittel.

Durch einen Versatz der Kraftführungsmittel in Längsrichtung kann gewährleistet werden, dass alle zu testenden bzw. zu kontaktierenden Halbleiterelemente gleichmäßig in eine Richtung senkrecht zur Längsrichtung pressbar sind, um dort von den Kontaktierungspins zuverlässig kontaktierbar zu sein. Die aufgebrachte Kraft kann also gleichmäßig, vorzugsweise über die gesamte Fläche, auf der die Halbleiterelemente anordenbar sind, verteilt werden.

Vorzugsweise weist jedes Rotationsmittel eine Rotationsmittel-Platte auf, welche im Wesentlichen parallel zu der Seitenwand ausgerichtet ist, an der das Rotationsmittel angeordnet ist, wobei die Rotations-Übertragungsmittel an entgegengesetzten Enden der Rotationsmittel-Platte befestigt sind.

Eine Rotationsmittel-Platte wird durch ein dünnes, ebenes Bauteil ausgebildet, das vorzugsweise eine rechteckige Form aufweist. An vorzugsweise gegenüberliegenden Enden der Rotationsmittel-Platte sind die Rotations-Übertragungsmittel rotierbar befestigt, so dass sich die Rotationsachsen der Rotations-Übertragungsmittel parallel zur Rotationsachse des Rotationsmittels erstrecken. Durch eine Rotation des Rotationsmittels sind die Rotationsachsen der Rotations-Übertragungsmittel in einer Kreisbahn um die feststehende Rotationsachse des Rotationsmittels bewegbar. Die Verschiebung der Rotationsachsen der Rotations-Übertragungsmittel um die Rotationsachse des Rotationsmittels ermöglicht wiederum die Verschiebung der Rotations-Übertragungsmittel in Längsrichtung.

Vorzugsweise weist die erste und/oder zweite Seitenwand zumindest zwei Seitenwand-Öffnungen auf, wobei jede Seitenwand-Öffnung derart positioniert und ausgebildet ist, dass ein entsprechendes Eingriffsmittel die Seitenwand durchdringen kann und in ein entsprechendes Kraftführungsmittel eingreifen kann.

In einer bevorzugten Ausführungsform umfasst jedes der Kraftführungsmittel eine Nockenlaufbahn.

Vorzugsweise weist diese Nockenlaufbahn ein erstes offenes Ende und ein zweites geschlossenes Ende auf, wobei die offenen Enden der in Längsrichtung zueinander versetzt angeordneten Kraftführungsmittel näher an dem zugeordneten Rotationsmittel sind als die geschlossenen Enden.

Durch die offenen Enden der Nockenlaufbahnen sind die Eingriffsmittel in die Nockenlaufbahnen einsetzbar. Durch eine Rotationsbewegung des Rotationsmittels sind die Rotations-Übertragungsmittel in Längsrichtung verschiebbar, wie bereits oben beschrieben. Durch die Verschiebung der Rotations-Übertragungsmittel in Längsrichtung sind die Eingriffsmittel von dem offenen Ende zu dem geschlossenen Ende der Nockenlaufbahn verschoben. Mit anderen Worten sind die Eingriffsmittel derart verschoben, dass sie am geschlossenen Ende der Nockenlaufbahn weiter von dem zugeordneten Rotationsmittel entfernt sind als an dem offenen Ende.

Vorzugsweise sind alle Nockenlaufbahnen identisch ausgebildet.

Vorzugsweise weist jede Nockenlaufbahn einen Steigungsbereich und einen steigungsfreien Bereich aufweist,
wobei der Steigungsbereich zwischen dem steigungsfreien Bereich und dem offenen Ende angeordnet ist, und wobei der steigungsfreie Bereich zwischen dem Steigungsbereich und dem geschlossenen Ende angeordnet ist.

Bevorzugterweise weist die Nockenlaufbahn eine obere Laufbahn und eine untere Laufbahn auf,
wobei in dem Steigungsbereich der Abstand zwischen der oberen Laufbahn und der unteren Laufbahn von dem offenen Ende zu dem steigungsfreien Bereich abnimmt, und
wobei die oberen Laufbahn und die untere Laufbahn in dem steigungsfreien Bereich im Wesentlichen parallel zueinander ausgerichtet sind.

An dem geschlossenen Ende in dem steigungsfreien Bereich befindet sich das entsprechende Eingriffsmittel in einer selbstgehemmten Position wodurch ein selbstständiges Öffnen des Gehäuse-Deckels vermieden wird. Die Länge des Steigungsbereichs und die Steigung der oberen Laufbahn in Bezug auf die untere Laufbahn in dem Steigungsbereich beeinflusst hingegen die Führung des Gehäuse-Deckels im Rahmen des Schließvorgangs. Insbesondere wird hierdurch die Kraft definiert, mit der das Deckelelement die Halbleiterelemente in eine Richtung senkrecht zu der Längsrichtung presst.

Bevorzugterweise umfasst das Eingriffsmittel ein Lagerelement ist und jedes Rotations-Übertragungsmittel einen Lagerelement-Verschiebearm.

Das Lagerelement ist vorzugsweise als rotationssymmetrisches Bauelement ausgebildet, um in vorteilhafter Weise in der Nockenlaufbahn verschiebbar zu sein. Der Lagerelement-Verschiebearm ist als längliches Bauelement ausgebildet, welches vorzugsweise als Stange oder Stab ausgeformt ist.

Vorzugsweise ist der Hebel von einer hinteren Seite zu einer vorderen Seite in Längsrichtung verschwenkbar ist und wobei der Hebel an der vorderen Seite mittels eines Fangarms fixierbar ist.

Die Definition "Längsrichtung" bezüglich der Verschieberichtung der Eingriffsmittel gilt entsprechend für die Verschwenkrichtung des Hebels.

Als hintere Seite des Testkontaktors wird vorzugsweise die Seite angesehen, an der der Gehäuses-Deckel beispielsweise mit dem Bodenelement des Gehäuses mittels eines Scharniers verbunden ist. Als Bodenelement kann jegliches Bauelement des Gehäuses dienen, das den Innenraum des Gehäuses zu einer Unterseite hin begrenzt.

Als vordere Seite des Gehäuses wird vorzugsweise die Seite angesehen, die der hinteren Seite entgegengesetzt ist.

Um ein ungewolltes Verschwenken des Hebels zu vermeiden sobald der Hebel zu der vorderen Seite verschwenkt ist, kann der Hebel mittels eines Fangarms fixiert werden, der vorzugsweise an dem Bodenelement angeordnet ist.

Gemäß einem zweiten Aspekt wird die zugrunde liegende Aufgabe durch ein Verfahren zum Kontaktieren von Halbleiterelementen gelöst, welches umfasst:
Bereitstellen eines Testkontaktors gemäß eines der vorangehenden beschriebenen Ausführungsformen,
Schließen des Gehäuse-Deckels,
Einsetzen der Eingriffsmittel in die Kraftführungsmittel;
Verschwenken des Hebels, so dass das Rotationsmittel rotiert wird und die Eingriffsmittel in Längsrichtung in den Kraftführungsmitteln von der ersten Position zu der zweiten Position verschoben werden, um in der zweiten Position selbstgehemmt zu sein.

Gemäß einem dritten Aspekt wird die zugrunde liegende Verwendung eines Testkontaktors gemäß einer der vorangehenden Ausführungsformen zum Testen von Halbleiterelementen gelöst.

Diese und andere Aufgaben, Merkmale und Vorteile der vorliegenden Erfindung werden aus dem Studium der folgenden detaillierten Beschreibung bevorzugter Ausführungsformen und der beiliegenden Zeichnungen deutlicher. Es ist ersichtlich, dass, obwohl Ausführungsformen separat beschrieben werden, einzelne Merkmale daraus zu zusätzlichen Ausführungsformen kombiniert werden können.
- Fig. 1: zeigt eine Gehäuse-Bodenplatte des Testkontaktors;
- Fig. 2: zeigt die Gehäuse-Bodenplatte aus Fig. 1 mit einem Basiselement, das an die Gehäuse-Bodenplatte geschraubt ist;
- Fig. 3: zeigt die Elemente des Testkontaktors aus Fig. 2 mit eingesetzten Kontaktierungseinheiten;
- Fig. 4: zeigt die Elemente des Testkontaktors aus Fig. 3 mit Abdeckplatten, die an dem Basiselement befestigt sind;
- Fig. 5: zeigt die Elemente des Testkontaktors aus Fig. 4 mit eingesetzter Leiterplatte;
- Fig. 6: zeigt einen Testkontaktor mit geöffnetem Gehäuse-Deckel
- Fig. 7: zeigt einen geschlossenen Testkontaktor ohne Deckelelement;
- Fig. 8: zeigt eine Seitenansicht eines Kraftführungselements
- Fig. 9: zeigt einen geschlossenen Testkontaktor.

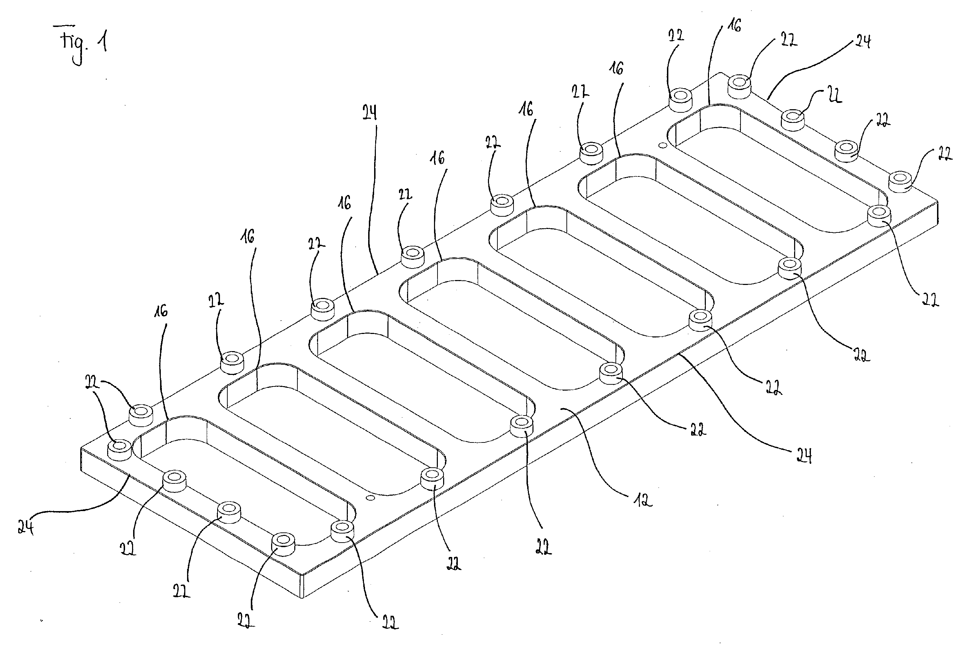

**Figur 1** zeigt einen Gehäuse-Bodenplatte 12 eines Gehäuses 14 für einen Testkontaktor 10 mit vorzugsweise einer Vielzahl von Bodenplatten-Öffnungen 16. Die Bodenplatten-Öffnungen 16 sind dabei derart angeordnet, dass später beschriebene Kontaktierungseinheiten 18, die in dem Testkontaktor 10 angeordnet sind, von einer Außenseite des Testkontaktors 10 zugänglich sind.

Auf der Gehäuse-Bodenplatte 12 ist ein Basiselement 20 (in Fig. 1 nicht gezeigt) angeordnet. Um eine verbesserte Wärmeausbreitung bzw. Ausbreitung warmer Luft in dem Testkontaktor 10 zu ermöglichen, ist jedoch vorzugsweise das Basiselement 20 nicht direkt auf der Gehäuse-Bodenplatte 12 angeordnet, sondern von dieser beabstandet. Dies kann, wie in Fig. 1 gezeigt, dadurch realisiert werden, dass zwischen der Gehäuse-Bodenplatte 12 und dem Basiselement 20 eine Vielzahl von Abstandshaltern 22 angeordnet ist. In dem in Fig. 1 gezeigten Fall ist die Vielzahl von Abstandshaltern 22 entlang der Außenkante 24 der Gehäuse-Bodenplatte 12 angeordnet. Die Abstandshalter 22 sind dabei als zylinderförmige Abstandshalter ausgebildet. Vorzugsweise weist das Basiselement 20 an der der Gehäuse-Bodenplatte 12 zugewandten Seite 26 Kerben (nicht gezeigt) auf, in denen die Abstandshalter 22 zumindest teilweise angeordnet sein können. Um die Abstandshalter 22 als auch das Basiselement 20 an der Gehäuse-Bodenplatte 12 zu fixieren, sind Basiselement-Fixierschrauben 28 durch entsprechende Bohrungen in dem Basiselement 20 und durch die Abstandshalter 22 hindurch in die Gehäuse-Bodenplatte 12 eingeschraubt.

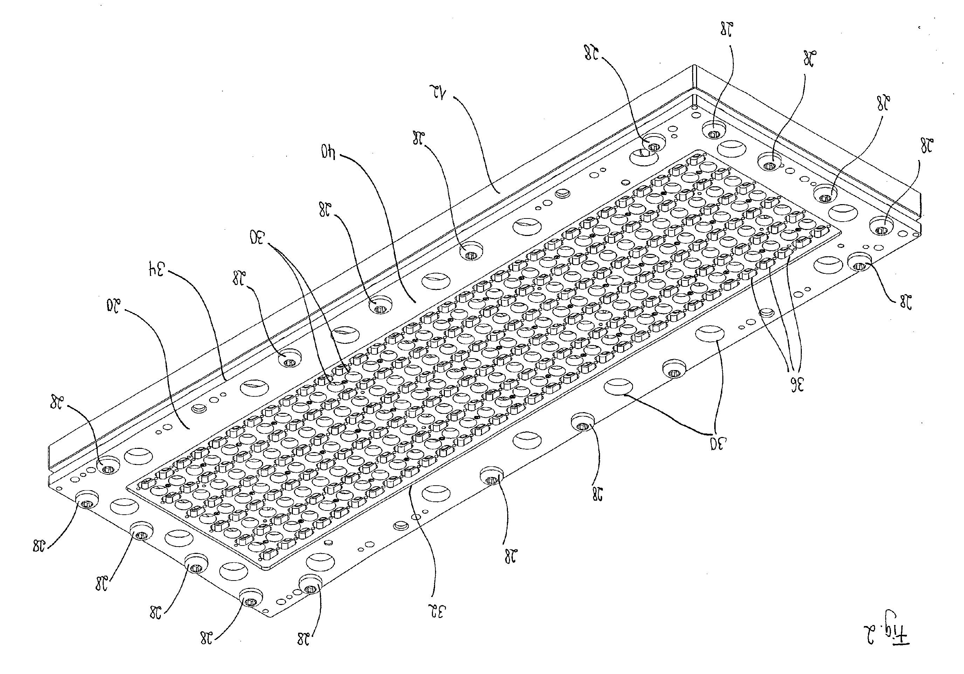

**Figur 2** zeigt die Gehäuse-Bodenplatte 12 mit dem Basiselement 20, das an der Gehäuse-Bodenplatte 12 angeordnet ist. Vorzugsweise, wie in Figur 2 gezeigt, ist das Basiselement 20 plattenförmig ausgebildet.

In einem Innenbereich 32 des Basiselements 20, der von der umlaufenden Außenkante 34 des Basiselements 20 beabstandet ist, ist eine Vielzahl von Basiselement-Öffnungen 36 ausgebildet. In jeder der Basiselement-Öffnungen 36 ist eine später näher beschriebene Kontaktierungseinheit 38 (nicht gezeigt in Figur 2) eingesetzt.

Vorzugsweise ist der Innenbereich 32 des Basiselements 20 im Verhältnis zu einem umlaufenden Basiselement-Randbereich 40 vertieft ausgebildet. Der Innenbereich 32 ist an der Seite des Basiselements 20, die von der Gehäuse-Bodenplatte 12 abgewandt ist, ausgebildet. Der Basiselement-Randbereich 40 erstreckt sich entlang der Außenkante 34 des Basiselements 20. In dem Basiselement-Randbereich 40 ist die Vielzahl von Basiselement-Fixierschrauben 28 eingeschraubt. In dem Basiselement-Randbereich 40 sowie in dem Innenbereich 32 sind vorzugsweise eine Vielzahl von Basiselement-Lüftungsöffnungen 30 ausgebildet, die zu einer verbesserten Wärmeausbreitung in dem Testkontaktor 10 beitragen.

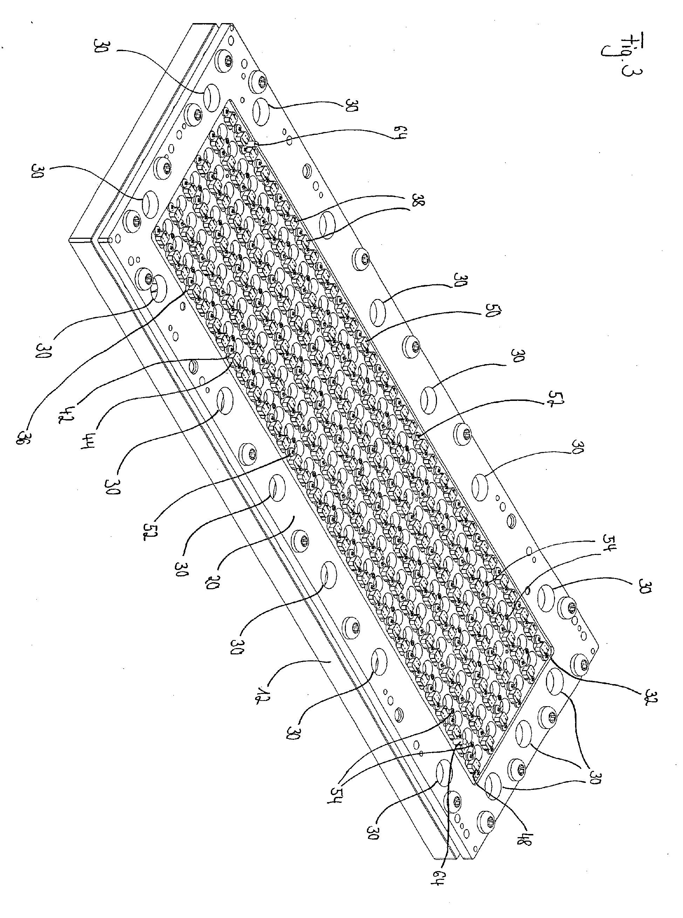

Wie in **Figur 3** gezeigt, ist jeweils eine Kontaktierungseinheit 38 in eine einzelne Basiselement-Öffnung 36 eingesetzt.

Jede Kontaktierungseinheit 38 weist einen Mittelbereich 42 und entgegengesetzte Endbereiche 44 auf. Der Mittelbereich 42 ist zwischen den Endbereichen 44 angeordnet und ist zumindest teilweise innerhalb der Basiselement-Öffnung 36 angeordnet. Um einen festen Sitz der Kontaktierungseinheit 38 innerhalb einer Basiselement-Öffnung 36 zu gewährleisten, entspricht die Außenfläche des Mittelbereichs 42 der Kontaktierungseinheit 38 der Form und Größe der Basiselement-Öffnung 36, so dass die Kontaktierungseinheit 38 in der Basiselement-Öffnung 36 ohne Verrutschen, im Wesentlichen ohne Spiel, gehalten werden kann.

Die Endbereiche 44 der Kontaktierungseinheit 38 sind an entgegengesetzten Enden des Mittelbereichs 42 angeordnet und ragen von entgegengesetzten Flächen des Basiselements 20 hervor.

Zur Kontaktierung von später beschriebenen Halbleiterelementen 46 (in Figur 3 nicht gezeigt), ist jeweils in den einzelnen Kontaktierungseinheiten 38 eine Vielzahl von Kontaktierungspins 48 eingesetzt. Hierzu sind in den Kontaktierungseinheiten 38 jeweils Kanäle 50 für die Kontaktierungspins 48 vorgesehen, die sich durch die Kontaktierungseinheit 38 hindurch erstrecken.

Um ein Einsetzen oder Wechseln der Kontaktierungspins 48 zu ermöglichen, sind die Kontaktierungseinheiten 38 vorzugsweise zweigeteilt. Bevorzugter Weise ist hierzu die Kontaktierungseinheit 38 in dem Mittelbereich 42 geteilt. Hierdurch wird ermöglicht, dass Kontaktierungspins 48, die stabförmig ausgebildet sind, in einem Mittelbereich (nicht gezeigt) einen größeren Durchmesser aufweisen können als in den Endbereichen der Kontaktierungspins 48. Eine derartige Form gewährleistet, dass ein Kontaktierungspin 48 nicht aus einer Kontaktierungseinheit 38 herausfallen kann. Mittels der zweigeteilten Kontaktierungseinheiten 38 sind derartig ausgeformte Kontaktierungspins 48 in einfacher Weise in die Kanäle 50 einsetzbar. Die Form und Größe der Kanäle 50 ist an die Kontaktierungspins 48 angepasst.

Die Anzahl der Kanäle 50 kann an die Anzahl der Kontaktierungspins 48 angepasst sein. Es ist jedoch ebenfalls möglich, dass, wie in Figur 3 gezeigt, mehr Kanäle 50 in den Kontaktierungseinheiten 38 vorgesehen sind als tatsächlich Kontaktierungspins 48 eingesetzt sind. Hierdurch wird ermöglicht, dass die Anzahl der Kontaktierungspins 48 an die Anzahl der Kontaktierungsarme der zu testenden Halbleiterelemente 46 angepasst werden kann.

Wie in Figur 3 gezeigt, ist der Umfang des Mittelbereichs 42 einer Kontaktierungseinheit 38 größer als der Umfang der Endbereiche 44 der Kontaktierungseinheit 38. Der hierdurch gebildete Sockel bietet die Möglichkeit, dass die Kontaktierungseinheit 38 an dem Basiselement 20 mittels einer Kontaktierungseinheit-Schraube 52 verschraubbar ist. Hierzu ist eine Kontaktierungseinheit-Schraube 52 in einem Randbereich um die Basiselement-Öffnung 36 eingeschraubt, wobei der Abstand zu der Basiselement-Öffnung 36 bzw. die Größe der Kontaktierungseinheit-Schraube 52 derart zu wählen ist, dass zumindest ein Teil des Kopfs der Kontaktierungseinheit-Schraube 52 den Sockel der Kontaktierungseinheit 38 überlappt. Vorzugsweise überlappt der Kopf einer Kontaktierungseinheit-Schraube 52 den Sockel mehrerer Kontaktierungseinheiten 38.

In dem Innenbereich 32 des Basiselements 20 ist weiterhin eine Vielzahl von Basiselement-Druckfedern 54 angeordnet, die vorzugsweise jeweils in entsprechenden Vertiefungen angeordnet sind. Die Basiselement-Druckfedern 54 können dabei vollständig in der Vertiefung angeordnet sein oder können über das Basiselement 20 hinaus ragen. Welche Alternative davon gewählt wird, hängt von der Konstruktion der später näher beschriebenen Abdeckplatten 56 ab, die an dem Basiselement 20 angeordnet sind. Im Speziellen hängt die zu wählende Alternative davon ab, ob Bereiche der Abdeckplatten 56, die mit den Basiselement-Druckfedern 54 in Kontakt treten, so ausgebildet sind, dass sie in die Vertiefungen für die Basiselement-Druckfedern 54 eindringen. Sollten die Abdeckplatten 56 derartige Bereiche nicht aufweisen, sind die Basiselement-Druckfedern 54 bzw. die entsprechenden Vertiefungen so zu wählen, dass die Basiselement-Druckfedern 54 über das Basiselement 20 hinaus ragen. Vorzugsweise weisen die Basiselement-Druckfedern 54 eine Federkonstante zwischen 0,05N/mm und 5N/mm und vorzugsweise zwischen 0,1 N/mm und 4Nmm. Vorzugsweise weisen die Basiselement-Druckfedern eine Federkonstante von 0,127N/mm oder 3N/mm auf.

Vorzugsweise sind an dem Basiselement 20 zwischen 10 und 100, vorzugsweise zwischen 20 und 80 und vorzugsweise zwischen 30 und 70 Druckfedern angeordnet.

Die Funktion der Basiselement-Druckfedern 54 wird später näher beschrieben.

Darüber hinaus ist an dem Basiselement 20, vorzugsweise in dem Innenbereich 32, eine Vielzahl von Positionierungspins 64 angeordnet, die an der den Abdeckplatten 56 zugewandten Seite des Basiselements 20 angeordnet ist. Diese sind derart lang gestaltet, dass diese die Abdeckplatten 56 durchdringen können und von den Abdeckplatten 56 hervorragen. Die einzusetzenden Leiterplatten weisen üblicherweise Leiterplatten-Öffnungen 66 auf, die als Referenzpunkte zur Positionsbestimmung der Halbleiterelemente auf der Leiterplatte ausgebildet sind. Im eingesetzten Zustand der Leiterplatte greifen die Positionierungspins 64 in die Leiterplatten-Öffnungen 66 ein.

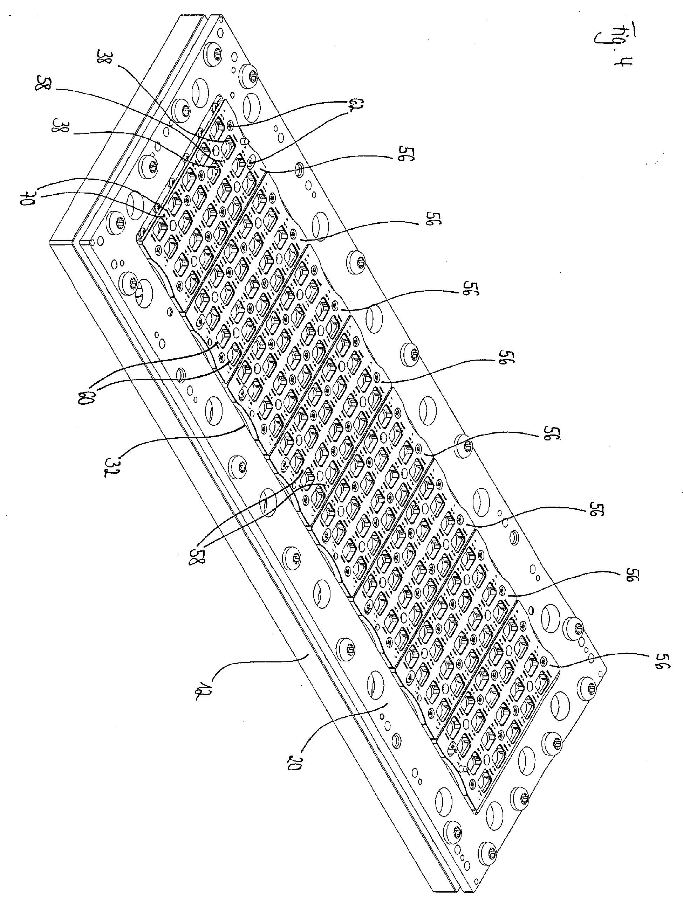

Wie in **Figur 4** gezeigt, ist an einer der Gehäuse-Bodenplatte 12 entgegengesetzten Seite des Basiselements 20 eine Vielzahl von Abdeckplatten 56 angeordnet, die vorzugsweise aus Kunststoff gefertigt ist. Die Vielzahl von Abdeckplatten 56 sind aneinander angrenzend angeordnet und weisen eine Gesamtgröße auf, die vorzugsweise dem Innenbereich 32 des Basiselements 20 entspricht. Insbesondere ist die Größe der Abdeckplatten 56 so gewählt, dass die Abdeckplatten 56 den Bereich des Basiselements 20 überlappen, in dem die Kontaktierungseinheiten 38 angeordnet sind.

Die Abdeckplatten 56 weisen eine Gitterstruktur mit einer Vielzahl von Gitterstreben 58 auf. Die sich aufgrund der Gitterstruktur zwischen den Gitterstreben 58 gebildeten Abdeckplatten-Öffnungen 60 sind vorzugsweise derart angeordnet, dass jeweils eine Abdeckplatten-Öffnung 60 eine Basiselement-Lüftungsöffnung 30 überlappt. Hierdurch wird eine vorteilhafte Wärmeausbreitung in dem Testkontaktor 10 ermöglicht.

Um die Abdeckplatten 56 an dem Basiselement 20 zu befestigen, ist eine Vielzahl von Abdeckplatten-Schrauben 62 in die Abdeckplatten eingeschraubt, die die Abdeckplatten 56 durchdringen und in das Basiselement 20 eingreifen.

Die Kontaktierungseinheiten 38 sind unter den Gitterstreben 58 angeordnet. Im Bereich der Kontaktierungseinheiten 38 sind an der dem Basiselement 20 zugewandten Seite der Abdeckplatten 56 Abdeckplatten-Vertiefungen 68 ausgebildet. In einer AbdeckplattenVertiefungen 68 ist zumindest bereichsweise eine Kontaktierungseinheit 38 aufgenommen. Vorzugsweise weist jede Abdeckplatten-Vertiefung 68 eine Größe und Form auf, die der Größe und Form eines Endbereichs 44 einer Kontaktierungseinheit 38 entspricht.

Weiterhin sind in jedem Bereich der Gitterstreben 58, der eine Kontaktierungseinheit 38 überlappt, Abdeckplatten-Pinöffnungen 70 vorgesehen. In jede der Abdeckplatten-Pinöffnungen 70 springt ein Kontaktierungspin 48 zumindest bereichsweise vor. Wie in Figur 4 gezeigt, ragen die Kontaktierungspins 48 nur geringfügig über die Abdeckplatten 56 hinaus. Vorzugsweise ragen die Kontaktierungspins 48 jedoch nicht über die Abdeckplatten 56 hinaus. Sind die Abdeckplatten 56 jedoch aufgrund einer später näher beschriebene rückstellfähigen Bewegung rückstellfähig verlagert, vergrößert sich der Teil der Kontaktierungspins 48, der über die Abdeckplatten 56 hinaus ragt, entsprechend. Ragen die Kontaktierungspins 48 in der ursprünglichen Position der Abdeckplatten 56 nicht über die Abdeckplatten 56 hinaus, ragen die Kontaktierungspins 48 von den Abdeckplatten 56 hervor, wenn die Abdeckplatten 56 rückstellfähig verlagert sind.

Wie bereits bezüglich der Anzahl der Kanäle 50 der Kontaktierungseinheiten 38 beschrieben, kann die Anzahl der Abdeckplatten-Pinöffnungen 70 größer sein als die Anzahl der tatsächlich vorhandenen Kontaktierungspins 48, so dass die Abdeckplatten 56 für verschiedene Kontaktierungseinheiten verwendet werden können.

Obwohl Figur 4 eine Vielzahl von Abdeckplatten 56 zeigt, ist es ebenfalls möglich, dass nur eine Abdeckplatte 56 vorgesehen ist.

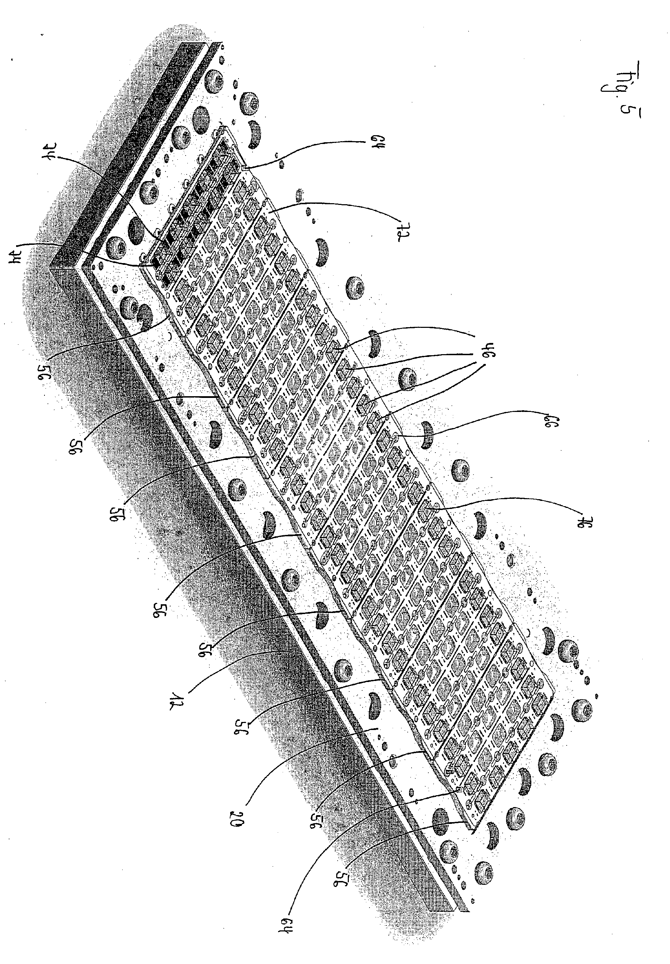

**Figur 5** zeigt die bisher beschriebenen Komponenten des Testkontaktors 10, in den eine Leiterplatte 72, auf der eine Vielzahl von Halbleiterelementen 46 angeordnet ist, eingesetzt ist.

Wie bereits oben beschrieben wurde, weist die Leiterplatte 72 eine Vielzahl von Leiterplatten-Öffnungen 66 auf. In jede Leiterplatten-Öffnung 66 greift ein Positionierungspin 64 ein, um die Position der Leiterplatte 72 zu fixieren.

Die Halbleiterelemente 46 sind dabei so positioniert, dass ein Halbleitergehäuse 76 jeweils über einer entsprechenden Abdeckplatten-Öffnung 60 angeordnet ist. Die Kontaktierungsarme bzw. Kontakierungsbonds 74 der Halbleiterelemente 46, die von entgegengesetzten Seiten eines Halbleitergehäuses 76 hervorragen, liegen auf Gitterstreben 58 auf. Insbesondere überlappt jeder Kontaktierungsarm 74 einen Bereich einer Gitterstrebe, in dem ein Kontaktierungspin 48 angeordnet ist, um von diesem kontaktiert zu werden.

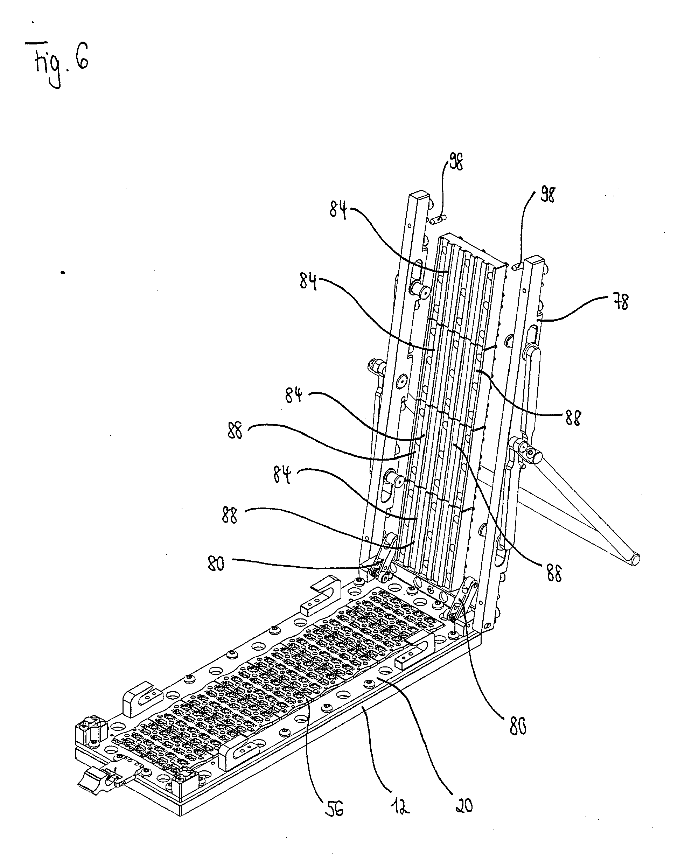

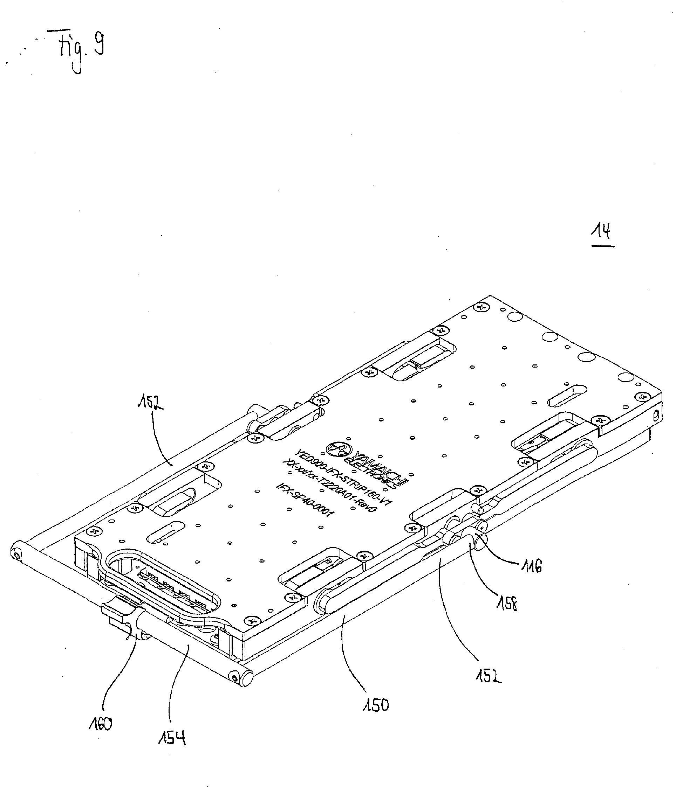

Um eine rückstellfähige Bewegung der Abdeckplatten 56 zusammen mit der Leiterplatte 72 zu erzielen, weist der Testkontaktor 10 einen Gehäuse-Deckel 78 auf, der vorzugsweise an dem Basiselement 20 mittels eines später näher beschriebenen Scharniers 80 befestigt ist. Der Gehäuse-Deckel 78 ist hierdurch zwischen einer offenen Position, wie in **Figur 6** gezeigt ist, und einer geschlossenen Position, wie in **Figur 9** gezeigt, verschwenkbar.

In einer offenen Position des Gehäuses 14 können Leiterplatten eingesetzt bzw. ausgetauscht werden. In einer geschlossenen Position drückt der Gehäuse-Deckel 78 auf die Leiterplatte 72 und/oder die Abdeckplatten 56, um diese rückstellfähig in eine Richtung zu dem Basiselement 20 zu bewegen und um die notwendige Kontaktierungskraft zu erzeugen, die benötigt wird, um die Kontaktierungsarme 74 der Halbleiterelemente 46 mittels der Kontaktierungspins 48 zu kontaktieren.

Vorzugsweise sind die Leiterplatte 71 bzw. die Abdeckplatten 56 mit einer Kraft zwischen 490 und 1970 N, vorzugsweise zwischen 670 und 1470 N und vorzugsweise zwischen 700 und 1100 N beaufschlagt, die der Gehäuse-Deckel 78 auf die Leiterplatte 71 bzw. die Abdeckplatten 56 aufbringt. Bevorzugterweise ist die Kraft etwa 700N. Ist die Kraft zwischen 700N und 1100N bedeutet dies einen Druck von 350N/mm bis 550N/mm.

Der Gehäuse-Deckel 78 weist ein Deckelelement 82 (in Figur 6 nicht gezeigt) auf, dass im geschlossenen Zustand des Gehäuses 14 vorzugsweise parallel zu den Abdeckplatten 56 bzw. der Leiterplatte 72 ausgerichtet ist.

Um Unebenheiten und Fertigungstoleranzen der Leiterplatte 72 auszugleichen und einen gleichmäßigen Druck bzw. eine gleichmäßige Kraft auf die Leiterplatte 72 und die Abdeckplatten 56 aufzubringen, weist der Gehäuse-Deckel 78 eine Vielzahl von Anpresselementen 84 auf. Die Anpresselemente 84 sind an einer den Abdeckplatten 56 zugewandten Seite des Gehäuseelements 82 angeordnet und sind vorzugsweise rechteckig ausgebildet.

Die Anpresselemente 84 sind aneinander angrenzend angeordnet und sind an dem Deckelelement 82 mittels Anpresselement-Schrauben 86 festgeschraubt. Die Größe und Position der Anpresselemente 84 sind so gewählt, dass sich die Anpresselemente 84 über die gesamte Fläche der Leiterplatte 72 und/oder der Abdeckplatten 56 erstrecken.

Um in verbesserter Weise eine gleichmäßigen Druck bzw. Kraft auf die Leiterplatte 72 und die Abdeckplatten 56 aufzubringen, sind vorzugsweise eine Vielzahl von Druckfedern (nicht gezeigt) zwischen dem Deckelelement 82 und den Anpresselementen 84 angeordnet.

An der den Abdeckplatten 56 bzw. der Leiterplatte 72 zugewandten Seite der Anpresselemente 84 sind vorzugsweise eine Vielzahl von Anpresselement-Aussparungen 88 ausgebildet, in denen die Halbleitergehäuse 76 zumindest teilweise angeordnet sind, wenn das Gehäuse 14 geschlossen ist. Es kann dabei für jedes Halbleitergehäuse 76 eine Anpresselement-Aussparung 88 vorgesehen sein oder eine Anpresselement-Aussparung 88 für eine Vielzahl von Halbleitergehäuse 76.

Obwohl Figur 6 eine Vielzahl von Anpresselementen 84 zeigt, kann auch nur ein Anpresselement 84 in dem Testkontaktor 10 vorhanden sein. Bei einem Anpresselement 84 ist die Größe des einzelnen Anpresselements 84 so gewählt, dass dieses vorzugsweise die gesamte eingesetzte Leiterplatte überdeckt.

Der Gehäuse-Deckel 78 weist zwei Seitenwände 90 auf, die parallel zueinander und voneinander beabstandet angeordnet sind. Der Abstand der Seitenwände 90 entspricht vorzugsweise der Testkontaktorgröße.

Flächen der beiden Seitenwände 90, die sich gegenüber liegen, werden als "Innenflächen" bezeichnet. Flächen der beiden Seitenwände 90, die parallel zu den Innenflächen ausgebildet sind, jedoch voneinander abgewandt sind, werden als "Außenflächen" bezeichnet.

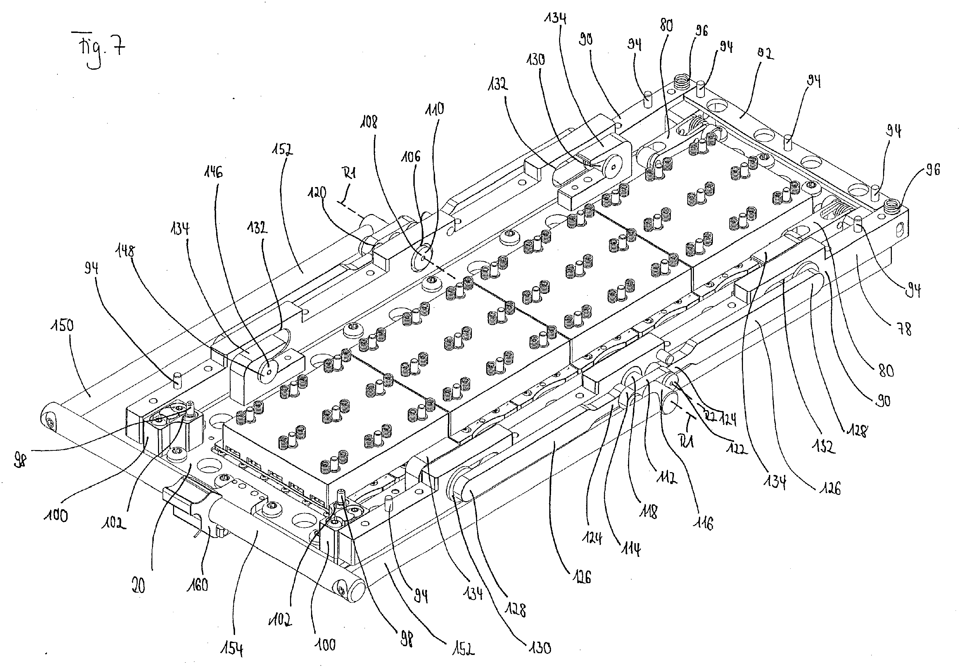

An zumindest einem Ende der Seitenwände 90 sind die beiden Seitenwände 90 mittels einer Deckelstrebe 92 verbunden, wie in Figur 7 gezeigt. Auf die Seitenwände 90 und auf die Deckelstrebe 92 ist das Deckelelement 82 (in Figur 7 nicht gezeigt) mittels Deckelelertient-Stifte 94 aufgesetzt. Die Deckelelement-Stifte 94 greifen in die Deckelstrebe 92 und in das Deckelelement 82 ein. Um eine federnde Lagerung des Deckelements 82 zu ermöglichen, ist vorzugsweise zumindest eine Druckfeder 96 zwischen jeder Seitenwand 90 und dem Deckelelement 82 angeordnet. Vorzugsweise ist jede Druckfeder 96 in einem Bereich angeordnet, in dem die Deckelstrebe 92 die beiden Seitenwände 90 verbindet.

Das Scharnier 80 umfasst zumindest zwei Scharnierelemente, die an dem Basiselement 20 und an der Deckelstrebe 92 befestigt sind. Vorzugsweise sind die Scharnierelemente federnd gelagert. Das Ende des Testkontaktors 10, an dem das Scharnier 80 angeordnet ist, wird als ein "hinteres Ende" bezeichnet. In Folge dessen wird das gegenüber liegende Ende des Testkontaktors 10 als "vorderes Ende" bezeichnet.

Die Richtungsangaben "vorne" und "hinten" beziehen sich auch entsprechend auf alle Bauteile des Testkontaktors 10.

An einem vorderen Ende des Deckelelements 82 ist vorzugsweise an Positionen nahe bzw. angrenzend an die Innenfläche der Seitenwände 90 jeweils ein Führungspin 98 angeordnet. Jeder Führungspin 98 ist an dem Deckelement 82 befestigt und erstreckt sich im geschlossenen Zustand des Gehäuses 14 in Richtung zu dem Basiselement 20.

An dem Basiselement 20 sind auf einer im geschlossenen Zustand des Gehäuses 14 dem Deckelelement 82 zugewandten Seite Führungsvorrichtungen 100 angeordnet. Jede Führungsvorrichtung 100 ist vorzugsweise mittels Schrauben an dem Basiselement 20 befestigt. Jede der Führungsvorrichtungen 100 weist einen Führungskanal 102 auf, in den ein entsprechender Führungspin 98 eintreten kann und während des Schließvorgangs des Gehäuse-Deckels führbar ist, so dass ein Verkanten des Gehäuse-Deckels 78 während des Schließvorgangs vermieden werden kann. Darüber hinaus wird die Position des Gehäuse-Deckels 78 im geschlossenen Zustand fixiert und ein Verrutschen des Gehäuse-Deckels 78 vermieden.

Um einen kontrollierten Schließvorgang des Gehäuse-Deckels 78 zu gewährleisten, weist der Gehäuse-Deckel 78 eine Hebelvorrichtung 104 auf, die an dem Gehäuse-Deckel 78 befestigt ist.

Hierzu weist jede Seitenwand 90 eine Lagerbohrung 106 auf, die sich in einer Richtung parallel zu dem Basiselement 20 durch die Seitenwände 90 erstreckt. Mit anderen Worten erstreckt sich die Lagerbohrung 106 senkrecht zu der Innenfläche und Außenfläche der der Seitenwand 90.

In jede Lagerbohrung 106 ist ein Lagerbolzen 108 eingesetzt. Ein Lagerbolzenkopf 110 jedes Lagerbolzens 108 ist an der Innenfläche der Seitenwand 90 angeordnet. Mit Hilfe der Lagerbolzen 108 wird jeweils ein Rotationselement 112 an den Seitenwänden 90 befestigt und drehbar um eine Rotationsachse R1 gelagert. Die Rotationsachse R1 ist senkrecht zu der Innenfläche und der Außenfläche der Seitenwand 90 ausgerichtet. Jedes Rotationselement 112 ist auf der Außenfläche der Seitenwände 90 angeordnet.

Das Rotationselement 112 weist eine Rotationselement-Platte 114 und einen ersten und zweiten Rotationselement-Vorsprung 116, 118 auf. Die Rotationselement-Platte 114 ist parallel zu der entsprechenden Seitenwand 90, an der das Rotationselement 112 befestigt ist, ausgerichtet. Weiterhin weist die Rotationselement-Platte 114 vorzugsweise eine rechteckige Form auf. Die ersten und zweiten Rotationselement-Vorsprünge 116, 118 sind an der Rotationselement-Platte 114 an entgegengesetzten Seiten der Rotationselement-Platte 114 angeordnet und ragen von der Rotationselement-Platte 114 entlang der Rotationsachse R1 des Rotationselements 112 vor.

Der zweite Rotationselement-Vorsprung 118 ist zwischen der Seitenwand 90 und der Rotationselement-Platte 114 angeordnet, während der erste Rotationselement-Vorsprung 116 von der Rotationselement-Platte 114 in eine Richtung von der Seitenwand 90 weg, an der das Rotationselement 112 befestigt ist, vorspringt.

An entgegengesetzten Enden der Rotationselement-Platte 114 ist jeweils eine Rotationselement-Bohrung 120 ausgebildet, so dass eine jeweilige Rotationsachse R2 der Rotationselement-Bohrungen 120 parallel zu der Rotationsachse R1 des Rotationselements 112 ausgerichtet ist. Wird das Rotationselement 112 gedreht, verändert sich die Position der Rotationsachse R1 des Rotationselements 112 nicht, während die Rotationsachsen R2 der Rotationselement-Bohrungen 120 entlang einer Kreisbahn um die Rotationsache R1 des Rotationselements 112 verschoben werden.

Mit Hilfe von Lagerbolzen 122, die jeweils in die Verbindungselement-Bohrungen 120 eingesetzt sind, wird jeweils ein erstes Ende 124 eines Lagerelement-Verschiebearms 126 drehbar an dem Rotationselement 112 befestigt. Vorteilhafterweise ist der Lagerelement-Verschiebearm 126 stabförmig ausgebildet.

Das jeweils zweite Ende 128 des Lagerelement-Verschiebearms 126 ist mit einem Lagerelement 130 verbunden, das sich zu der Seitenwand 90 hin erstreckt. Insbesondere erstreckt sich das Lagerelement 130 durch die Seitenwand 90 hindurch. Hierzu ist in jeder Seitenwand 90 in einem Bereich vor und einem Bereich hinter des Rotationselements 112 je eine Seitenwand-Öffnung 132 vorhanden, durch die sich jeweils ein Lagerelement 130 hindurch erstreckt. Die Seitenwand-Öffnung 132 ist in Form eines Langlochs ausgebildet, in dem das Lagerelement 130 in einer Richtung zu und weg von der Rotationsachse R1 des Verbindungselements 112 verschiebbar ist. Im Speziellen ist jede Seitenwand-Öffnung 132 als Langloch ausgebildet, das sich in einer Längsrichtung des Testkontaktors 10 erstreckt. Als Längsrichtung wird die Richtung verstanden, die sich von einem hinteren Ende zu einem vorderen Ende des Testkontaktors 10 erstreckt. Durch ein Verschieben des Lagerelements 130 in einer Seitenwand-Öffnung 132 führt das Lagerelement eine lineare Bewegung in einer Längsrichtung aus. Die Bewegung des Lagerelements 130 innerhalb der Seitenwand-Öffnung 132 wird durch eine Drehbewegung des Rotationselements 112 ausgelöst.

An dem Basiselement 20 ist eine Vielzahl von Kraftführungselementen 134 befestigt, die sich im geschlossenen Zustand des Gehäuses 14 von dem Basiselement 20 in Richtung zu dem Deckelement 82 hin erstrecken. Je ein Kraftführungselement 134 ist an einer Innenseite der Seitenwände 90 in einem Bereich angeordnet, der eine Seitenwand-Öffnung 132 überlappt. Mit anderen Worten weist der Testkontaktor 10 vier Kraftführungselemente 134 auf.

In jedem der Kraftführungselemente 134 ist eine Nockenlaufbahn 136 ausgebildet, in die jeweils eines der oben beschriebenen Lagerelemente 130 eingreift und in dieser verschiebbar gelagert ist. Die Nockenlaufbahn 136 weist jeweils ein erstes offenes Ende 138 und ein zweites geschlossenes Ende 140 auf, wobei das offene Ende 138 jeder Nockenlaufbahn 136 näher an dem jeweiligen Rotationselement 112 angeordnet ist als das geschlossene Ende 140.

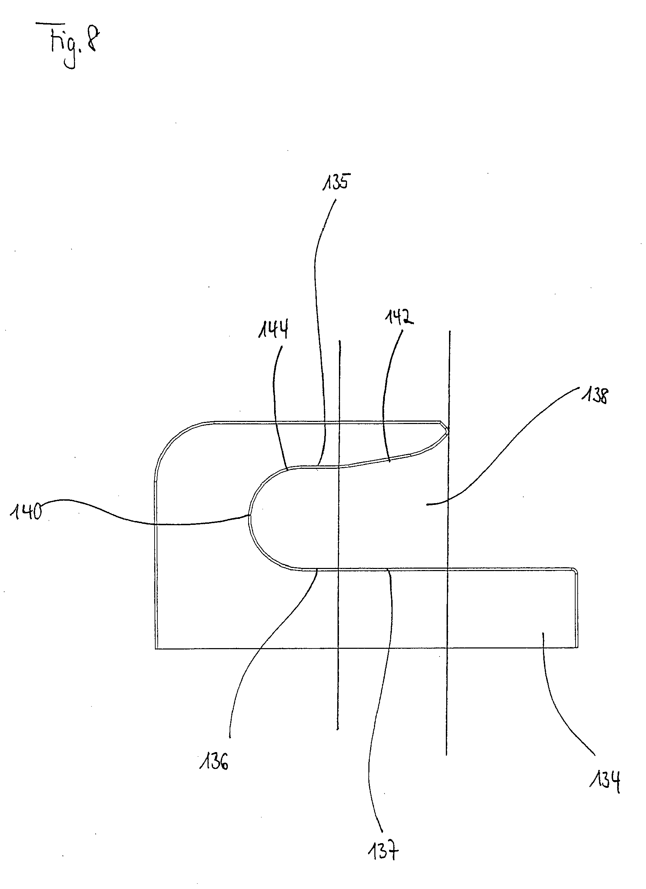

Wie in **Figur 8** gezeigt, weist jede der Nockenlaufbahnen 136 einen Steigungsbereich 142 und einen steigungsfreien Bereich 144 auf. Der Steigungsbereich 142 zwischen dem steigungsfreien Bereich 144 und dem offenen Ende 138 angeordnet ist. Der steigungsfreie Bereich 144 ist zwischen dem Steigungsbereich 142 und dem geschlossenen Ende 140 angeordnet.

Die Nockenlaufbahn 136 weist eine obere Laufbahn 135 und eine untere Laufbahn 137 auf. Die untere Laufbahn 137 ist die Laufbahn, die näher an dem Basiselement 20 ausgebildet ist, während die obere Laufbahn 135 die Laufbahn ist, die im geschlossenen Zustand des Gehäuses 14 näher an dem Deckelelement 82 ist.

In dem Steigungsbereich 142 nimmt die Steigung von dem offenen Ende 138 zu dem steigungsfreien Bereich 144 hin ab. Dies wird erzielt, in dem der Abstand der oberen Laufbahn 135 von der unteren Laufbahn 137 abnimmt. Vorzugsweise ist der Abstand zwischen der oberen Laufbahn 135 und der unteren Laufbahn 137 in dem Steigungsbereich am offenen Ende 138 zwischen 10mm und 18mm, vorzugsweise zwischen 12mm und 16mm und vorzugsweise zwischen 14mm und 15mm. Vorzugsweise ist der Abstand zwischen der oberen Laufbahn 135 und der unteren Laufbahn 137 in dem Steigungsbereich 142 am offenen Ende 138 10,4mm oder 11,12mm. Der Abstand zwischen der oberen Laufbahn 135 und der unteren Laufbahn 137 nimmt bis zum steigungsfreien Bereich 144 ab, wo er dann vorzugsweise zwischen 4mm und 12mm, vorzugsweise zwischen 6mm und 10mm und vorzugsweise zwischen 8 und 9 mm beträgt. Vorzugsweise ist der Abstand zwischen der oberen Laufbahn 135 und der unteren Laufbahn 137 dort 8,4mm. Ist der Abstand zwischen der oberen Laufbahn 135 und der unteren Laufbahn 137 in dem Steigungsbereich 142 am offenen Ende 138 11,12mm und an der Grenze zu dem steigungsfreien Bereich 144 8,4mm, verringert sich somit der Abstand um 2,72mm. Die Länge der oberen Laufbahn 135 in dem Steigungsbereich 142 beträgt vorzugsweise zwischen 1 mm und 10mm, vorzugsweise zwischen 2mm und 8mm und vorzugsweise 2,72mm. Wie in Figur 8 gezeigt, ist hierzu die obere Laufbahn 135 schräg zu der unteren Laufbahn 137 ausgerichtet. Vorzugsweise erstreckt sich die untere Laufbahn 137 parallel zu dem Basiselement 20.

In dem steigungsfreien Bereich 144 weist die Nockenlaufbahn 136 keine Steigung auf. Hierzu verändert sich der Abstand zwischen der oberen Laufbahn 135 und der unteren Laufbahn 137 in dem steigungsfreien Bereich 144 nicht. Mit anderen Worten sind die oberen Laufbahn 135 und die untere Laufbahn 137 in dem steigungsfreien Bereich 144 im Wesentlichen parallel zueinander ausgerichtet. Vorzugsweise verlaufen die oberen Laufbahn 135 und die untere Laufbahn 137 parallel zu dem Basiselement 20.

Mit Hilfe eines Lagerelement-Bolzens 146 ist das Lagerelement 130 an dem entsprechenden Lagerelement-Verschiebearm 126 befestigt. Der Kopf 148 des Lagerelement-Bolzens 146 ist an einer Seite des Kraftführungselements 134 angeordnet, die der Seitenwand 90 abgewandt ist. Der Kopf 148 des Lagerelement-Bolzens 146 kann hierdurch als Begrenzungselement genutzt werden, um eine zuverlässige Führung des Lagerelements 130 in der Nockenlaufbahn 136 zu gewährleisten.

Vorteilhafterweise kontaktieren sich die Kraftführungselemente 134 und die jeweilige Seitenwand 90, an der die Kraftführungselemente 134 jeweils angeordnet sind, so dass die Lagerelemente 130 so kurz wie möglich gestaltet werden können.

In einer bevorzugten Ausführungsform weist das Lagerelement 130 einen ersten Lagerelement-Teil und einen zweiten Lagerelement-Teil auf. Der erste Lagerelement-Teil des Lagerelements 130 ist in dem Bereich der Seitenwand-Öffnung 132 angeordnet. Der zweite Lagerelement-Teil des Lagerelements 130 ist im geschlossenen Zustand des Gehäuses 14 in der Nockenlaufbahn 136 angeordnet ist, um in dieser geführt zu werden.

In einem Schließvorgang des Gehäuse-Deckels 78 werden zunächst die Lagerelemente 130 in die jeweiligen Nockenlaufbahnen 136 über die offenen Enden 138 der Nockenlaufbahn 136 eingesetzt. Mit Hilfe eines Hebels 150, der an den Rotationselementen 112 befestigt ist, kann dann das Lagerelement 130 in der Nockenlaufbahn 136 zu dem geschlossenen Ende 140 der Nockenlaufbahn 136 verschoben werden. Hierzu wird der Hebel 150 verschwenkt, wodurch die Rotationselemente 112 eine Rotationsbewegung um die Rotationsachse R1 durchführen. Aufgrund der Rotationsbewegung der Rotationselemente 112 verschieben sich die Rotationsachsen R2, wodurch die Lagerelement-Verschiebearme 126 in Längsrichtung verschoben werden. Insbesondere werden die Lagerelemente 130, die in einer Seitenwand 90 angeordnet sind, durch das Verschwenken des Hebels 150 weiter auseinander geschoben.

Im Speziellen weist der Hebel 150 zwei Hebelarme 152 aufweist, die parallel voneinander beabstandet angeordnet sind und deren erste Enden 156 mittels eines Griffelements 154 verbunden sind. Die zweiten Enden 158 der Hebelarme 152 sind jeweils mit einem der ersten Rotationselement-Vorsprünge 116 fest verbunden. Beispielsweise werden die Hebelarme 152 mit den ersten Verbindungselement-Vorsprüngen 116 verschraubt. Die Hebelarme 152 können jedoch auch integral mit den Rotationselementen 112 ausgebildet sein.

Vorzugsweise ist der Hebel 150 um 180° verschwenkbar an dem Gehäuse-Deckel 78 angeordnet.

Sobald die Lagerelemente 130 in die Nockenlaufbahnen 136 eingesetzt wurden, wird der Hebel 150 von einer hinteren Seite zu einer vorderen Seite verschwenkt bis sich die Hebelarme 152 in Längsrichtung erstrecken. In dieser Endposition des Hebels 150 erreichen die Lagerelemente 130 das geschlossene Ende 140 der Nockenlaufbahn 136, wodurch eine Selbsthemmung erzielt wird.

Durch die Führung der Lagerelemente 130 entlang des Steigungsbereichs 142 wird der Gehäuse-Deckel 78 zu dem Basiselement 20 in kontrollierter Weise hingezogen. Mit Hilfe der Länge und der Steigung des Steigungsbereichs 142 kann die Kraft definiert werden, mit der der Gehäuse-Deckel 78 bzw. die Anpresselemente 84 auf die Abdeckplatten 56 bzw. die Leiterplatte 72 pressen. Die notwendige Kraft ist die Kraft, die dazu notwendig ist, die Abdeckplatten 56 rückstellfähig zu bewegen und die Kontaktierungsarme bzw. Kontaktierungsbonds 74 der Halbleiterelemente 46 mittels der Kontaktierungspins 48 zu kontaktieren.

Um den Hebel 150 in der Endposition zu fixieren, ist an dem Basiselement 20 zumindest ein Fangarm 160 angeordnet, der von dem Basiselement 20 über die Außenkante des Basiselements 20 hinausragt. Sobald der Hebel 150 vollständig in seine Endposition verschwenkt wurde, rastet das Griffelement 154 in den Fangarm 160 ein (siehe **Figur 9**). Somit kann ein ungewolltes weiteres Verschwenken des Hebels 150 vermieden werden.

### Bezugszeichenliste

- 10: Testkontaktor
- 12: Gehäuse-Bodenplatte
- 14: Gehäuse
- 16: Bodenplatten-Öffnung
- 18: Kontaktierungseinheit
- 20: Basiselement
- 22: Abstandshalter
- 24: Außenkante der Gehäuse-Bodenplatte
- 26: der Gehäuse-Bodenplatte zugewandte Seite des Basiselements
- 28: Basiselement-Fixierschraube
- 30: Basiselement-Lüftungsöffnung
- 32: Innenbereich
- 34: Außenkante des Basiselements
- 36: Basiselement-Öffnung
- 38: Kontaktierungseinheit
- 40: Basiselement-Randbereich
- 42: Mittelbereich der Kontaktierungseinheit
- 44: Endbereich der Kontaktierungseinheit
- 46: Halbleiterelement
- 48: Kontaktierungspin
- 50: Kanal
- 52: Kontaktierungseinheit-Schraube
- 54: Basiselement-Druckfeder
- 56: Abdeckplatte
- 58: Gitterstrebe
- 60: Abdeckplatten-Öffnung
- 62: Abdeckplatten-Schraube
- 64: Positionierungspin
- 66: Leiterplatten-Öffnung
- 68: Abdeckplatten-Vertiefung
- 70: Abdeckplatten-Pinöffnung
- 72: Leiterplatte
- 74: Kontaktierungsarm des Halbleiterelements
- 76: Halbleitergehäuse
- 78: Gehäuse-Deckel
- 80: Scharnier
- 82: Deckelelement
- 84: Anpresselement
- 86: Anpresselement-Schraube
- 88: Anpresselement-Aussparung
- 90: Seitenwand
- 92: Deckelstrebe
- 94: Deckelelement-Stift
- 96: Druckfeder
- 98: Führungspin
- 1O0: Führungsvorrichtung
- 102: Führungskanal
- 104: Hebelvorrichtung
- 106: Lagerbohrung
- 108: Lagerbolzen
- 110: Lagerbolzenkopf
- 112: Rotationselement
- 114: Rotationselement-Platte
- 116: erster Rotationselement-Vorsprung
- 118: zweiter Rotationselement-Vorsprung
- 120: Rotationselement-Bohrung
- 122: Lagerbolzen
- 124: erstes Ende des Lagerelement-Verschiebearms
- 126: Lagerelement-Verschiebearm
- 128: zweites Ende des Lagerelement-Verschiebearms
- 130: Lagerelement
- 132: Seitenwand-Öffnung
- 134: Kraftführungselement
- 136: Nockenlaufbahn
- 138: offenes Ende der Nockenlaufbahn
- 140: geschlossenes Ende der Nockenlaufbahn
- 142: Steigungsbereich
- 144: steigungsfreier Bereich
- 146: Lagerelement-Bolzen
- 148: Kopf des Lagerelement-Bolzens
- 150: Hebel
- 152: Hebelarm
- 154: Griffelement
- 156: erstes Ende des Hebelarms
- 158: zweites Ende des Hebelarms
- 160: Fangarm

- R1: Rotationsachse des Rotationselements
- R2: Rotationsachse der Rotationselement-Bohrung

## Patentansprüche

1. Testkontaktor (10) zum Kontaktieren von Halbleiterelementen (46), umfassend:
ein Gehäuse (14) mit einem Gehäuse-Deckel (78) zum Öffnen des Gehäuses (14), wobei in einem Innenraum des Gehäuses (14) Halbleiterelemente (46) anordenbar sind;
wobei der Gehäuse-Deckel (78) umfasst:
- eine erste Seitenwand (90) und eine zweite Seitenwand (90), die sich gegenüberliegen;
- ein Deckelelement (82), das die erste Seitenwand (90) und die zweite Seitenwand (90) verbindet und im geschlossenen Zustand des Gehäuses (14) im Wesentlichen parallel zu den Halbleiterelementen (46) anordenbar ist; und
- eine Hebelvorrichtung, welche an einer der Seitenwände (90) angeordnet ist;
wobei die Hebelvorrichtung umfasst:
- ein erstes Rotationsmittel (112), welches an einer Außenseite der ersten Seitenwand (90) rotierbar angeordnet ist;
- zwei erste Rotations-Übertragungsmittel, welche mit dem ersten Rotationsmittel (112) rotierbar verbunden sind, und wobei jedes der ersten Rotations-Übertragungsmittel ein erstes Eingriffsmittel aufweist;
- zwei erste Kraftführungsmittel (134), welche gegenüberliegend zu einer Innenseite der ersten Seitenwand (90) angeordnet sind, wobei jedes der ersten Eingriffsmittel dazu ausgelegt ist, in ein entsprechend zugeordnetes erstes Kraftführungsmittel (134) einzugreifen, wenn das Gehäuse (14) geschlossen wird;
- einen Hebel (150), welcher mit dem ersten Rotationsmittel (112) verbunden ist und der dazu ausgelegt ist, das erste Rotationsmittel (112) durch ein Verschwenken des Hebels (150) zu rotieren;
wobei die ersten Eingriffsmittel durch eine Rotationsbewegung des ersten Rotationsmittels (112) in den ersten Kraftführungsmitteln (134) in Längsrichtung zwischen einer ersten Position und einer zweiten Position verschiebbar sind; und
wobei die ersten Eingriffsmittel in der zweiten Position selbstgehemmt sind, so dass ein selbstständiges Öffnen des Gehäuse-Deckels (78) verhindert wird.

2. Testkontaktor (10) gemäß Anspruch 1, wobei die Hebelvorrichtung an der ersten und der zweiten Seitenwand (90, 90) angeordnet ist; und
wobei die Hebelvorrichtung zusätzlich umfasst:
- ein zweites Rotationsmittel (112), welches an einer Außenseite der zweiten Seitenwand (90) rotierbar angeordnet ist;
- zwei zweite Rotations-Übertragungsmittel, welche mit dem zweiten Rotationsmittel (112) rotierbar verbunden sind, und wobei jedes der zweiten Rotations-Übertragungsmittel ein zweites Eingriffsmittel aufweist;
- zwei zweite Kraftführungsmittel (134), welche gegenüberliegend zu einer Innenseite der zweiten Seitenwand (90) angeordnet sind, wobei jedes der zweiten Eingriffsmittel dazu ausgelegt ist, in ein entsprechend zugeordnetes zweites Kraftführungsmittel (134) einzugreifen, wenn das Gehäuse (14) geschlossen wird;
wobei der Hebel (150) mit dem ersten und zweiten Rotationsmittel (112, 112) verbunden ist und der dazu ausgelegt ist, das erste und zweite Rotationsmittel (112, 112) durch ein Verschwenken des Hebels (150) zu rotieren;
wobei die zweiten Eingriffsmittel durch eine Rotationsbewegung des zweiten Rotationsmittels (112) in den zweiten Kraftführungsmitteln (134) in Längsrichtung zwischen einer ersten Position und einer zweiten Position verschiebbar sind; und
wobei die zweiten Eingriffsmittel in der zweiten Position selbstgehemmt sind, so dass ein selbstständiges Öffnen des Gehäuse-Deckels (78) verhindert wird.

3. Testkontaktor (10) gemäß Anspruch 1 oder 2, wobei die Rotations-Übertragungsmittel, die mit demselben Rotationsmittel (112) verbunden sind, durch eine Verschenkbewegung des Hebels (150) in Längsrichtung zueinander verschiebbar sind.

4. Testkontaktor (10) gemäß einem der vorangehenden Ansprüche, wobei die Kraftführungsmittel (134) ausgebildet sind, die einzusetzenden Halbleiterelemente (46) während des Schließvorgangs des Gehäuses (14) durch das Deckelelement (82) mit einem vordefinierten Kraftverlauf in eine Richtung senkrecht zur Längsrichtung zu drücken.

5. Testkontaktor (10) gemäß einem der vorangehenden Ansprüche, wobei die Kraftführungsmittel (134), die derselben Innenseite einer Seitenwand (90) gegenüberliegen, in Längsrichtung zueinander versetzt sind.

6. Testkontaktor (10) gemäß einem der vorangehenden Ansprüche, wobei jedes Rotationsmittel (112) eine Rotationsmittel-Platte (114) aufweist, welche im Wesentlichen parallel zu der Seitenwand (90) ausgerichtet ist, an der das Rotationsmittel (112) angeordnet ist, wobei die Rotations-Übertragungsmittel an entgegengesetzten Enden der Rotationsmittel-Platte (114) befestigt sind.

7. Testkontaktor (10) gemäß einem der vorangehenden Ansprüche, wobei die erste und/oder zweite Seitenwand (90, 90) zumindest zwei Seitenwand-Öffnungen (132) aufweist, wobei jede Seitenwand-Öffnung (132) derart positioniert und ausgebildet ist, dass ein entsprechendes Eingriffsmittel die Seitenwand (90) durchdringen kann und in ein entsprechendes Kraftführungsmittel (134) eingreifen kann.

8. Testkontaktor (10) gemäß einem der vorangehenden Ansprüche, wobei jedes der Kraftführungsmittel (134) eine Nockenlaufbahn (136) umfasst.

9. Testkontaktor (10) gemäß Anspruch 8, wobei die Nockenlaufbahn (136) ein erstes offenes Ende (138) und ein zweites geschlossenes Ende (140) aufweist, wobei die offenen Enden (138) der in Längsrichtung zueinander versetzt angeordneten Kraftführungsmittel (134) näher an dem zugeordneten Rotationsmittel (112) sind als die geschlossenen Enden (140).

10. Testkontaktor (10) gemäß Anspruch 8 oder 9, wobei jede Nockenlaufbahn (136) einen Steigungsbereich (142) und einen steigungsfreien Bereich (144) aufweist,
wobei der Steigungsbereich (142) zwischen dem steigungsfreien Bereich (144) und dem offenen Ende (138) angeordnet ist, und wobei der steigungsfreie Bereich (144) zwischen dem Steigungsbereich (142) und dem geschlossenen Ende (140) angeordnet ist.

11. Testkontaktor (10) gemäß Anspruch 10, wobei die Nockenlaufbahn (136) eine obere Laufbahn (135) und eine untere Laufbahn (137) aufweist,
wobei in dem Steigungsbereich (142) der Abstand zwischen der oberen Laufbahn (135) und der unteren Laufbahn (137) von dem offenen Ende zu dem steigungsfreien Bereich (144) abnimmt, und
wobei die oberen Laufbahn (135) und die untere Laufbahn (137) in dem steigungsfreien Bereich (144) im Wesentlichen parallel zueinander ausgerichtet sind.

12. Testkontaktor (10) gemäß einem der vorangehenden Ansprüche, wobei das Eingriffsmittel ein Lagerelement (130) ist und jedes Rotations-Übertragungsmittel einen Lagerelement-Verschiebearm (126) umfasst.

13. Testkontaktor (10) gemäß einem der vorangehenden Ansprüche, wobei der Hebel (150) von einer hinteren Seite zu einer vorderen Seite des Gehäuses (14) in Längsrichtung verschwenkbar ist und wobei der Hebel (150) an der vorderen Seite mittels eines Fangarms (160) fixierbar ist.

14. Verfahren zum Kontaktieren von Halbleiterelementen (46), umfassend:
Bereitstellen eines Testkontaktors (10) gemäß einem der vorangehenden Ansprüche,
Schließen des Gehäuse-Deckels (78),
Einsetzen der Eingriffsmittel in die Kraftführungsmittel (134);
Verschwenken des Hebels (150), so dass das Rotationsmittel (112) rotiert wird und die Eingriffsmittel in Längsrichtung in den Kraftführungsmitteln (134) von der ersten Position zu der zweiten Position verschoben werden, um in der zweiten Position selbstgehemmt zu sein.

15. Verwendung eines Testkontaktors (10) gemäß einem der Ansprüche 1 bis 13 zum Testen von Halbleiterelementen (46).
